# EUROPEAN PATENT APPLICATION

(11) **EP 1 612 840 A2**
(43) Date of publication of application: **04.01.2006**
(21) Application number: 05252818.9
(22) Date of filing: 09.05.2005
(51) Int. Cl.: H01J 37/32

(54) **Method and apparatus for photomask plasma etching**

(30) Priority: 30.06.2004 US 882084
(71) Applicant: APPLIED MATERIALS, INC., Santa Clara, California 95054 (US)
(72) Inventor: Kumar, Ajay, Cupertino California 95014 (US); Chandrachood, Madhavi, Sunnyvale California 94086 (US); Anderson, Scott Alan, Livermore California 94551 (US); Satitpunwaycha, Peter, Sunnyvale California 94089 (US); Yau, Wai Fan, Los Altos California 94022 (US)
(74) Representative: Bayliss, Geoffrey Cyril

(57) **Abstract**

A method and apparatus for etching photomasks is provided herein. In one embodiment, a method of etching a photomask includes providing a process chamber (102) having a substrate support pedestal (124) adapted to receive a photomask substrate thereon. An ion-radical shield (170) is disposed above the pedestal (124). A substrate (122) is placed upon the pedestal beneath the ion-radical shield (170). A process gas is introduced into the process chamber and a plasma is formed from the process gas. The substrate is etched predominantly with radicals that pass through the shield.

## Description

Embodiments of the present invention generally relate to a method and apparatus for plasma etching photomasks and, more specifically, to a method and apparatus for etching photomasks using a quasi-remote plasma.

In the manufacture of integrated circuits (IC), or chips, patterns representing different layers of the chip are created by a chip designer. A series of masks, or photomasks, are created from these patterns in order to transfer the design of each chip layer onto a semiconductor substrate during the manufacturing process. Mask pattern generation systems use precision lasers or electron beams to image the design of each layer of the chip onto a respective mask. The masks are then used much like photographic negatives to transfer the circuit patterns for each layer onto a semiconductor substrate. These layers are built up using a sequence of processes and translate into the tiny transistors and electrical circuits that comprise each completed chip. Thus, any defects in the mask may be transferred to the chip, potentially adversely affecting performance. Defects that are severe enough may render the mask completely useless. Typically, a set of 15 to 30 masks is used to construct a chip and can be used repeatedly.

The mask is typically a glass or a quartz substrate that has a layer of chromium on one side. The mask may also contain a layer of silicon nitride (SiN) doped with molybdenum (Mb). The chromium layer is covered with an anti-reflective coating and a photosensitive resist. During a patterning process, the circuit design is written onto the mask by exposing portions of the resist to ultraviolet light, making the exposed portions soluble in a developing solution. The soluble portion of the resist is then removed, allowing the exposed underlying chromium to be etched. The etch process removes the chromium and anti-reflective layers from the mask at locations where the resist was removed, *i*.*e*., the exposed chromium is removed.

In one etch process, known as dry etching, reactive ion etching, or plasma etching, a plasma is used to enhance a chemical reaction on the exposed area of the mask, thus removing the desired layers. Undesirably, the etch process does not produce a perfect replica of the circuit design patterned onto the mask. Some shrinkage of the pattern occurs in the etched mask due to the profile of the photoresist for chromium etch and the selectivity of the mask material. This shrinkage is referred to as etch bias. In addition, the etch bias may not be uniform across the entire mask. This phenomena is referred to as critical dimension uniformity, or CDU. In conventional mask etching processes, the etch bias is typically in the range of about 60 to 70 nanometers (nm) and the CDU is in the range of about 10 to 15 nm. Required tolerances for 65 nm scale features are about 20 nm for etch bias and about 5 nm for critical dimension uniformity. Thus, as the node size of features formed on the chip continue to shrink, the capabilities of existing processes become less and less desirable, particularly as the node size approaches the 65 nm scale.

Therefore, there is a need for an improved etch process for manufacturing photomasks.

The present invention generally provides a method and apparatus for etching photomasks. In one embodiment, a method of etching a photomask includes providing a process chamber having a substrate support pedestal adapted to receive a photomask substrate (sometimes referred to in the art as a photomask reticle) thereon. An ion-radical shield is disposed above the pedestal. A substrate is placed upon the pedestal beneath the ion-radical shield. A process gas is introduced into the process chamber and a plasma is formed from the process gas. The substrate is etched predominantly with radicals that pass through the shield.

In another aspect of the invention, an apparatus is provided for etching a photomask substrate. In one embodiment, a process chamber has a substrate support pedestal disposed therein. The pedestal is adapted to support a photomask substrate. An RF power source is coupled to the chamber for forming a plasma within the chamber. An ion-radical shield is disposed in the chamber above the pedestal. The shield is adapted to control the spatial distribution of charged and neutral species of the plasma. The shield includes a substantially flat member electrically isolated from the chamber walls and comprises a plurality of apertures that vertically extend through the flat member.

So that the manner in which the above recited features of the present invention can be understood in detail, a more particular description of the invention, briefly summarized above, may be had by reference to embodiments, some of which are illustrated in the appended drawings. It is to be noted, however, that the appended drawings illustrate only typical embodiments of this invention and are therefore not to be considered limiting of its scope, for the invention may admit to other equally effective embodiments.

Figure 1 is a schematic diagram of an etch reactor having a ion-radical shield;

Figure 2 is a partial perspective view of one embodiment of the ion-radical shield of Figure 1; and

Figure 3 is a flow chart of a method of etching a photomask.

The present invention provides a method and apparatus for improving etching of lithographic photomasks, or reticles. The apparatus includes an ion-radical shield disposed in a plasma processing chamber. The ion-radical shield controls the spatial distribution of the charged and neutral species in the chamber during processing. The ion-radical shield is disposed between the plasma and the reticle, such that the plasma is formed in a quasi-remote, upper processing region of the chamber above the shield.

In one embodiment, the ion-radical shield comprises a ceramic plate having one or more apertures formed therethrough. The plate is disposed in the chamber above the pedestal. The plate is electrically isolated from the walls of the chamber and the pedestal such that no ground path from the plate to ground is provided. During processing, a potential develops on the surface of the plate as a result of electron bombardment from the plasma. The potential attracts ions from the plasma, effectively filtering them from the plasma, while allowing neutrally charged radicals to pass through the apertures of the plate. Thus, the ion-radical shield substantially prevents ions from reaching the surface of the reticle being etched while allowing radicals to react with and etch the reticle in a more controlled manner, thereby reducing erosion of the photomask resist as well as reducing sputtering of the resist onto the sidewalls of the patterned chromium. The reduced erosion and sputtering thus improves the etch bias and critical dimension uniformity.

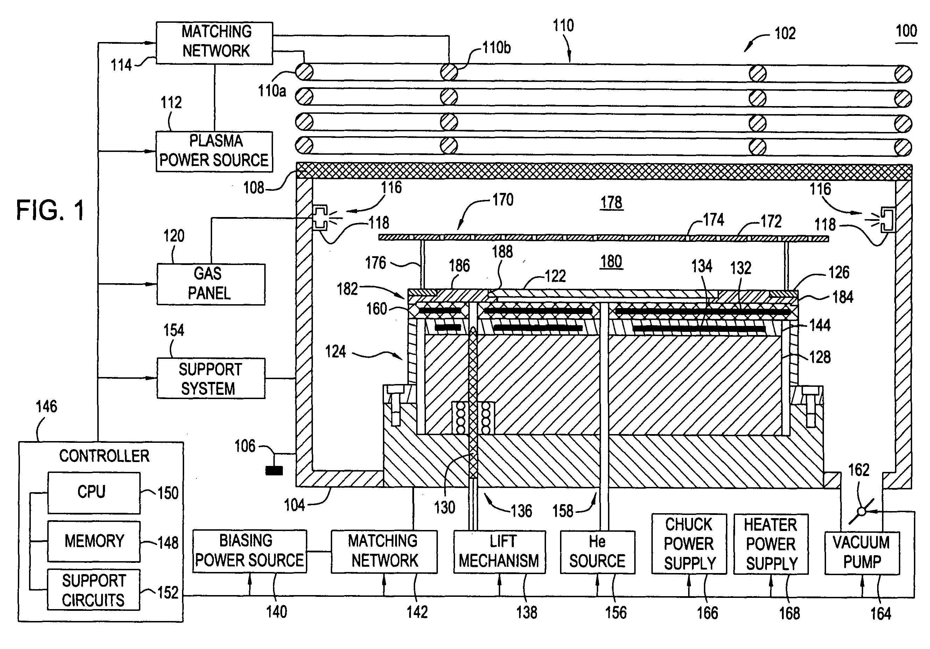

Figure 1 depicts a schematic diagram of an etch reactor 100 having a ion-radical shield 170. Suitable reactors that may be adapted for use with the teachings disclosed herein include, for example, the Decoupled Plasma Source (DPS®) II reactor, or the Tetra I and Tetra II Photomask etch systems, all of which are available from Applied Materials, Inc. of Santa Clara, California. The DPS® II reactor may also be used as a processing module of a Centura® integrated semiconductor wafer processing system, also available from Applied Materials, Inc. The particular embodiment of the reactor 100 shown herein is provided for illustrative purposes and should not be used to limit the scope of the invention.

The reactor 100 generally comprises a process chamber 102 having a substrate pedestal 124 within a conductive body (wall) 104, and a controller 146. The chamber 102 has a substantially flat dielectric ceiling 108. Other modifications of the chamber 102 may have other types of ceilings, e.g., a dome-shaped ceiling. An antenna 110 is disposed above the ceiling 108. The antenna 110 comprises one or more inductive coil elements that may be selectively controlled (two co-axial elements 110a and 110b are shown in Figure 1). The antenna 110 is coupled through a first matching network 114 to a plasma power source 112. The plasma power source 112 is typically capable of producing up to about 3000 W at a tunable frequency in a range from about 50 kHz to about 13.56 MHz.

The substrate pedestal (cathode) 124 is coupled through a second matching network 142 to a biasing power source 140. The biasing source 140 generally is a source of up to about 500 W at a frequency of approximately 13.56 MHz that is capable of producing either continuous or pulsed power. Alternatively, the source 140 may be a DC or pulsed DC source.

In one embodiment, the substrate support pedestal 124 comprises an electrostatic chuck 160. The electrostatic chuck 160 comprises at least one clamping electrode 132 and is controlled by a chuck power supply 166. In alternative embodiments, the substrate pedestal 124 may comprise substrate retention mechanisms such as a susceptor clamp ring, a mechanical chuck, and the like.

A reticle adapter 182 is used to secure the substrate (reticle) 122 onto the substrate support pedestal 124. The reticle adapter 182 generally includes a lower portion 184 milled to cover an upper surface of the pedestal 124 (for example, the electrostatic chuck 160) and a top portion 186 having an opening 188 that is sized and shaped to hold the substrate 122. The opening 188 is generally substantially centered with respect to the pedestal 124. The adapter 182 is generally formed from a single piece of etch resistant, high temperature resistant material such as polyimide ceramic or quartz. A suitable reticle adapter is disclosed in U. S. Patent No. 6,251,217, issued on June 26, 2001, which is incorporated herein by reference to the extent not inconsistent with aspects and claims of the invention. An edge ring 126 may cover and/or secure the adapter 182 to the pedestal 124.

A lift mechanism 138 is used to lower or raise the adapter 182, and hence, the substrate 122, onto or off of the substrate support pedestal 124. Generally, the lift mechanism 162 comprises a plurality of lift pins 130 (one lift pin is shown) that travel through respective guide holes 136.

In operation, the temperature of the substrate 122 is controlled by stabilizing the temperature of the substrate pedestal 124. In one embodiment, the substrate support pedestal 124 comprises a resistive heater 144 and a heat sink 128. The resistive heater 144 generally comprises at least one heating element 134 and is regulated by a heater power supply 168. A backside gas (e.g., helium (He)) from a gas source 156 is provided via a gas conduit 158 to channels that are formed in the pedestal surface under the substrate 122. The backside gas is used to facilitate heat transfer between the pedestal 124 and the substrate 122. During processing, the pedestal 124 may be heated by the embedded resistive heater 144 to a steady-state temperature, which in combination with the helium backside gas, facilitates uniform heating of the substrate 122. Using such thermal control, the substrate 122 may be maintained at a temperature between about 0 and 350 degrees Celsius.

An ion-radical shield 170 is disposed in the chamber 102 above the pedestal 124. The ion-radical shield 170 is electrically isolated from the chamber walls 104 and the pedestal 124 and generally comprises a substantially flat plate 172 and a plurality of legs 176. The plate 172 is supported in the chamber 102 above the pedestal by the legs 176. The plate 172 defines one or more openings (apertures) 174 that define a desired open area in the surface of the plate 172. The open area of the ion-radical shield 170 controls the quantity of ions that pass from a plasma formed in an upper process volume 178 of the process chamber 102 to a lower process volume 180 located between the ion-radical shield 170 and the substrate 122. The greater the open area, the more ions can pass through the ion-radical shield 170. As such, the size of the apertures 174 control the ion density in volume 180. Consequently, the shield 170 is an ion filter.

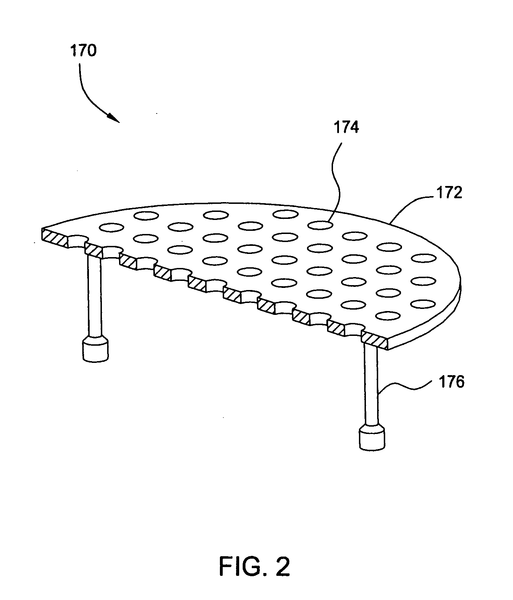

Figure 2 depicts a perspective view of one specific embodiment of the shield 170. In this embodiment, the ion-radical shield 170 comprises a plate 172 having a plurality of apertures 174 and a plurality of legs 176. The plate 172 may be fabricated of a ceramic (such as alumina), quartz, anodized aluminum, or other materials compatible with process chemistries. In another embodiment, the plate 172 could comprise a screen or a mesh wherein the open area of the screen or mesh corresponds to the desired open area provided by the apertures 174. Alternatively, a combination of a plate and screen or mesh may also be utilized.

The plurality of apertures 174 may vary in size, spacing and geometric arrangement across the surface of the plate 172. The size of the apertures 174 generally range from 0.03 inches (0.07 cm) to about 3 inches (7.62 cm). The apertures 174 may be arranged to define an open area in the surface of the plate 172 of from about 2 percent to about 90 percent. In one embodiment, the one or more apertures 174 include a plurality of approximately half-inch (1.25 cm) diameter holes arranged in a square grid pattern defining an open area of about 30 percent. It is contemplated that the holes may be arranged in other geometric or random patterns utilizing other size holes or holes of various sizes. The size, shape and patterning of the holes may vary depending upon the desired ion density in the lower process volume 180. For example, more holes of small diameter may be used to increase the radical to ion density ratio in the volume 180. In other situations, a number of larger holes may be interspersed with small holes to increase the ion to radical density ratio in the volume 180. Alternatively, the larger holes may be positioned in specific areas of the plate 172 to contour the ion distribution in the volume 180.

The height at which the ion-radical shield 170 is supported may vary to further control the etch process. The closer the ion-radical shield 170 is located to the ceiling 108, the smaller the upper process volume 178. A small upper process volume 178 promotes a more stable plasma. In one embodiment, the ion-radical shield 170 is disposed approximately 1 inch (2.54 cm) from the ceiling 108. A faster etch rate may be obtained by locating the ion-radical shield 170 closer to the pedestal 124 and, therefore, the substrate 122. Alternatively, a lower, but more controlled, etch rate may be obtained by locating the ion-radical shield 170 farther from the pedestal 124. Controlling the etch rate by adjusting the height of the ion-radical shield 170 thus allows balancing faster etch rates with improved critical dimension uniformity and reduced etch bias. In one embodiment, the ion-radical shield 170 is disposed approximately 2 inches (5 cm) from the pedestal 124. The height of the ion-radical shield 170 may range from about 1.5 inches (3.81 cm) to about 4 inches (10.16 cm) in a chamber having a distance of about 6 inches (15.24 cm) between the substrate 122 and the ceiling 108. It is contemplated that the ion-radical shield 170 may be positioned at different heights in chambers having different geometries, for example, larger or smaller chambers.

To maintain the plate 172 in a spaced-apart relationship with respect to the substrate 122, the plate 172 is supported by a plurality of legs 176 disposed on the pedestal 124. The legs 176 are generally located around an outer perimeter of the pedestal 124 or the edge ring 126 and may be fabricated of the same materials as the plate 172. In one embodiment, three legs 176 may be utilized to provide a stable support for the ion-radical shield 170. The legs 176 generally maintain the plate in a substantially parallel orientation with respect to the substrate 122 or pedestal 124. However, it is contemplated that an angled orientation may be used by having legs 176 of varied lengths.

An upper end of the legs 176 may be press fit into a corresponding hole formed in the plate 172. Alternatively, the upper end of the legs 176 may be threaded into the plate 172 or into a bracket secured to an underside of the plate 172. Other conventional fastening methods not inconsistent with processing conditions may also be used to secure the legs 176 to the plate 176.

The legs 176 may rest on the pedestal 124, adapter 182, or the edge ring 126. Alternatively, the legs 176 may extend into a receiving hole (not shown) formed in the pedestal 124, adapter 182, or edge ring 126. Other fastening methods are also contemplated for securing the ion-radical shield 170 to the pedestal 124, adapter 182, or edge ring 126, such as by screwing, bolting, bonding, and the like. When secured to the edge ring 126, the ion-radical shield 170 may be part of an easily-replaceable process kit for ease of use, maintenance, replacement, and the like. It is contemplated that the ion-radical shield 170 may be configured to be easily retrofitted in existing process chambers.

Alternatively, the plate 172 may be supported above the pedestal 124 by other means such as by using a bracket (not shown) attached to the wall 104 or other structure within the process chamber 102. Where the plate 172 is attached to the wall 104 or other structure of the process chamber 102, the plate 172 is generally insulated from any ground path such as the ground 106.

Returning to Figure 1, one or more process gases are provided to the process chamber 102 from a gas panel 120. The process gases are typically supplied through one or more inlets 116 (e.g., openings, injectors, and the like) located above the substrate pedestal 124. In the embodiment depicted in Figure 1, the process gases are provided to the inlets 116 using an annular gas channel 118. The gas channel 118 may be formed in the wall 104 or in gas rings (as shown) that are coupled to the wall 104. During an etch process, the process gases are ignited into a plasma by applying power from the plasma source 112 to the antenna 110.

The pressure in the chamber 102 is controlled using a throttle valve 162 and a vacuum pump 164. The temperature of the wall 104 may be controlled using liquid-containing conduits (not shown) that run through the wall 104. Typically, the chamber wall 104 is formed from a metal (e.g., aluminum, stainless steel, and the like) and is coupled to an electrical ground 106. The process chamber 102 also comprises conventional systems for process control, internal diagnostic, endpoint detection, and the like. Such systems are collectively shown as support systems 154.

The controller 146 comprises a central processing unit (CPU) 644, a memory 148, and support circuits 152 for the CPU 150 and facilitates control of the components of the process chamber 102 and, as such, of the etch process, as discussed below in further detail. The controller 146 may be one of any form of general-purpose computer processor that can be used in an industrial setting for controlling various chambers and sub-processors. The memory, or computer-readable medium, 642 of the CPU 150 may be one or more of readily available memory such as random access memory (RAM), read only memory (ROM), floppy disk, hard disk, or any other form of digital storage, local or remote. The support circuits 152 are coupled to the CPU 150 for supporting the processor in a conventional manner. These circuits include cache, power supplies, clock circuits, input/output circuitry and subsystems, and the like. The inventive method is generally stored in the memory 148 as a software routine. Alternatively, such software routine may also be stored and/or executed by a second CPU (not shown) that is remotely located from the hardware being controlled by the CPU 150.

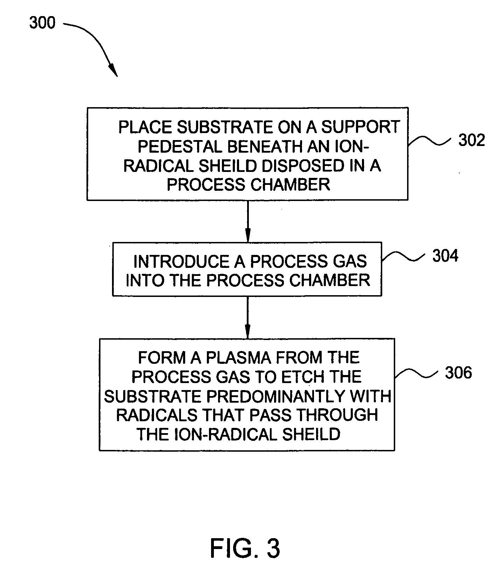

One exemplary method 300 for using the ion-radical shield 170 to etch a reticle substrate is depicted in the flow chart of Figure 3 and illustrated with respect to Figure 1. The method 300 begins at step 302 when the substrate 122 is placed on a support pedestal 124 beneath an ion radical shield 170 disposed in a process chamber 102. The ion radical shield 170 is positioned about 2 inches (5 cm) above the pedestal 124. The substrate 122 rests in the opening 188 of the adapter 182. Typical substrates 122 generally comprise an optically transparent silicon based material, such as quartz (*i*.*e*., silicon dioxide, SiO₂), having an opaque light-shielding layer of metal, known as a photomask material, disposed on the surface of the quartz. Metals used in a photomask typically include chromium or chromium oxynitride. The substrate 122 may also include a layer of silicon nitride (SiN) doped with molybdenum (Mo) interposed between the quartz and chromium.

At step 304, one or more process gases are introduced into the process chamber 102 through the gas inlet 116. Exemplary process gases may include oxygen (O₂) or an oxygen containing gas, such as carbon monoxide (CO), and/or a halogen containing gas, such as a chlorine containing gas for etching the metal layer. The processing gas may further include an inert gas or another oxygen containing gas. Carbon monoxide is advantageously used to form passivating polymer deposits on the surfaces, particularly the sidewalls, of openings and patterns formed in a patterned resist material and etched metal layers. Chlorine containing gases are selected from the group of chlorine (Cl₂), silicon tetrachloride (SiCl₄), boron trichloride (BCl₃), and combinations thereof, and are used to supply highly reactive radicals to etch the metal layer.

In one embodiment, the substrate 122 comprising chromium is etched using the Tetra I, Tetra II, or DPS® II etch module by providing chlorine at a rate of 10 to 1000 standard cubic centimeters per minute (sccm), oxygen at a rate of 0 to 1000 sccm. A substrate bias power between 5 and 500 W is applied to the electrostatic chuck 160 and the substrate 122 is maintained at a temperature in a range of less than about 150 degrees Celsius. The pressure in the process chamber is controlled between about 1 and about 40 mTorr. One specific process recipe provides chlorine at a rate of 80 sccm and oxygen at a rate of 20 sccm, applies 15 W of bias power, maintains a substrate temperature of less than 150 degrees Celsius, and maintains a pressure of 2 mTorr. The process provides etch selectivity for chromium over photoresist of at least 1:1.

At step 320 a plasma is formed from the one or more process gases to etch the substrate 122 predominantly with radicals that pass through the ion-radical shield 170. The plasma is generally formed in the upper process volume 178 by applying RF power of between about 200 to about 2000 W from the plasma power source 112 to the antenna 110. In one embodiment, RF power at a power level of about 350 W is applied to the antenna 110 at a frequency of from about 13.56 MHz.

When the RF power is applied at step 320, a plasma is formed and electrons bombard the plate to form a potential on the surface of the ion-radical shield 170. This potential attracts the ions present in the plasma and limits the number of ions that pass through the apertures 174 into the lower process volume 180. The neutral radicals in the plasma pass through the apertures 174 in the ion-radical shield 170 into the lower process volume 180. Thus, the substrate 122 is predominantly etched by the radicals formed by the plasma while the quantity of ions striking the substrate 122 is controlled. The reduction in ion impingement on the substrate 122 reduces the etch bias and improves the critical dimension uniformity of the substrate 122. Specifically, measurements taken after etching substrates using the aforementioned process revealed that the etch bias was reduced to less than 10 nm and good vertical profiles where observed on the chrome sidewalls. Specifically, the sidewalls were observed to have an angle no greater than 89 degrees. A sharp profile with substantially no relief, or foot, was observed at the interface between the bottom of the etched area and the sidewall. In addition, the critical dimension uniformity improved to less than 5 nm.

While the foregoing is directed to embodiments of the present invention, other and further embodiments of the invention may be devised without departing from the basic scope thereof, and the scope thereof is determined by the claims that follow.

## Claims

1. An apparatus for plasma etching, comprising:
a process chamber;
a substrate support pedestal disposed in the process chamber and adapted to receive a photomask reticle thereon;
an RF power source for forming a plasma within the chamber; and
an ion-radical shield disposed in the chamber above the pedestal and adapted to control the spatial distribution of charged and neutral species of the plasma.

2. An apparatus as claimed in claim 1, wherein the RF power source is inductively coupled to the process chamber.

3. An apparatus as claimed in claim 1 or claim 2, wherein the apertures are about 1.25 cm in diameter.

4. An apparatus as claimed in any of claims 1 to 3, wherein the shield is disposed about 5 cm above the substrate.

5. An apparatus as claimed in any of claims 1 to 4, wherein the shield further comprises:
a substantially flat member electrically isolated from the chamber; and
a plurality of apertures.

6. An apparatus as claimed in claim 5, wherein the member is fabricated from at least one of ceramic, quartz, or anodized aluminum.

7. An apparatus as claimed in claim 5 or claim 6, wherein the member further comprises:
a plate having the plurality of apertures formed therethrough.

8. An apparatus as claimed in claim 7, wherein the apertures have a hole size, shape, position, and distribution over the surface of the plate to define an ion to radical density ratio proximate the substrate.

9. An apparatus as claimed in claim 7 or claim 8, comprising:
a plurality of support legs supporting the plate above the pedestal.

10. An apparatus as claimed in claim 9, wherein the legs support the plate in a substantially parallel, spaced apart relation with respect to the pedestal.

11. An apparatus as claimed in claim 9 or claim 10, further comprising:
an edge ring disposed about a perimeter of an upper surface of the support pedestal and having the plurality of support legs extending therefrom.

12. An apparatus as claimed in any of claims 7 to 11, wherein the plate is fabricated from at least one of ceramic, quartz, or anodized aluminum.

13. A method of etching a photomask, comprising:
providing a process chamber having a substrate support pedestal adapted to receive a photomask reticle thereon and an ion-radical shield disposed above the pedestal;
placing a reticle upon the pedestal;
introducing a process gas into the process chamber;
forming a plasma from the process gas; and
etching the reticle predominantly with radicals that pass through the shield.

14. A method as claimed in claim 13, wherein the step of etching further comprises:
forming a potential upon a surface of the shield.

15. A method as claimed in claim 13 or claim 14, wherein the step of introducing a process gas further comprises:
introducing a chlorine containing gas into the chamber.

16. A method as claimed in any of claims 13 to 15, wherein the step of forming a plasma further comprises:
inductively coupling RF power to an antenna disposed proximate the process chamber.

17. A method as claimed in any of claims 13 to 16, wherein the step of etching the substrate predominantly with radicals further comprises:
defining a hole size, shape, position, and distribution over the surface of the shield to control the ion to radical density ratio proximate the reticle.

18. A method of etching a photomask, comprising:
providing a process chamber having a substrate support pedestal adapted to receive a photomask reticle thereon and an ion-radical shield disposed above the pedestal;
placing a reticle having an exposed chromium layer to be etched upon the pedestal;
applying a reticle bias power between about 5 and about 500 Watts;
introducing a halogen containing process gas into the process chamber;
forming a plasma from the process gas by applying an RF power between about 200 and about 2000 Watts; and
etching the reticle predominantly with radicals that pass through the shield.

19. A method as claimed in claim 18, wherein the step of introducing a halogen containing process gas further comprises:
introducing a chlorine containing gas into the process chamber.

20. A method as claimed in claim 18 or claim 19, further comprising:
introducing an oxygen containing gas into the process chamber.

21. An apparatus for plasma etching, comprising:
a process chamber;
a substrate support pedestal disposed in the process chamber and adapted to receive a photomask reticle thereon;
an RF power source for forming a plasma within the chamber; and
means for controlling the spatial distribution of charged and neutral species of the plasma.

22. A method of etching a photomask, comprising:
forming a plasma comprising ions and radicals in a first region of a chamber;
filtering radicals from the plasma; and
etching a photomask substrate predominantly with radicals that are filtered from the plasma.
